# EUROPEAN PATENT APPLICATION

(11) **EP 4 672 012 A1**
(43) Date of publication of application: **31.12.2025**
(21) Application number: 25186059.9
(22) Date of filing: 27.06.2025
(51) Int. Cl.: G06F 15/78

(54) **MEMORY-COMPUTING INTEGRATED CHIP ARCHITECTURE, PACKAGING METHOD AND APPARATUS**

(30) Priority: 27.06.2024 CN 202410852997
(71) Applicant: Hangzhou Zhicun (Witmem) Technology Co., Ltd., Hangzhou, Zhejiang 311100 (CN)
(72) Inventor: WANG, Shaodi, HANGZHOU, ZHEJIANG, 311100 (CN); GUO, Xinjie, HANGZHOU, ZHEJIANG, 311100 (CN)
(74) Representative: Lucke, Andreas

(57) **Abstract**

The present disclosure relates to the technical field of memory-computing integrated chips, and in particular, to a memory-computing integrated chip architecture, a packaging method and an apparatus for a memory-computing integrated chip. The memory-computing integrated chip architecture includes: a plurality of first chips, each integrated with one or more arrays of memory-computing integrated cells, wherein the one or more arrays of memory-computing integrated cells are used for computing with received data; and one or more second chips, each integrated with one or more peripheral circuit IP cores, wherein the one or more arrays of memory-computing integrated cells are coupled to the one or more peripheral circuit IP cores via one or more communication paths, and wherein the one or more communication paths are arranged based on one or more of an operation property and an arrangement of the one or more arrays of memory-computing integrated cells of the plurality of first chips.

## Description

### TECHNICAL FIELD

The present disclosure relates to the technical field of memory-computing integrated chips, and in particular, to a memory-computing integrated chip architecture, a packaging method and an apparatus.

### BACKGROUND

The von Neumann architecture on which computers typically operate includes two separate parts, namely, a memory and a processor. When instructions are executed, data needs to be written to the memory, instructions and data are read from the memory in sequence by the processor, and finally execution results are written back to the memory. Accordingly, data is frequently transmitted between the processor and the memory. If a transmission speed of the memory cannot match an operating speed of the processor, a computing capability of the processor may be limited. For example, it takes 1 ns for the processor to execute an instruction, while it takes 10 ns for the instruction to be read from the memory and to be transmitted. This significantly reduces the operating speed of the processor, and thus reduces performance of an entire computing system.

Methods described in this section are not methods that have been previously conceived or employed. It should not be assumed that any of the methods described in this section is considered to be the prior art because it is included in this section, unless otherwise indicated expressly. Similarly, the problem mentioned in this section should not be considered to be recognized in any prior art, unless otherwise indicated expressly.

### SUMMARY

According to a first aspect of the present disclosure, a memory-computing integrated chip architecture is provided. The memory-computing integrated chip architecture includes: a plurality of first chips, each integrated with one or more arrays of memory-computing integrated cells, wherein the one or more arrays of memory-computing integrated cells are used for computing with received data; and one or more second chips, each integrated with one or more peripheral circuit **IP** cores, wherein the one or more arrays of memory-computing integrated cells are coupled to the one or more peripheral circuit **IP** cores via one or more communication paths, and wherein the one or more communication paths are arranged based on one or more of an operation property and an arrangement of the one or more arrays of memory-computing integrated cells of the plurality of first chips.

According to a second aspect of the present disclosure, a packaging method for a memory-computing integrated chip is provided. The packaging method includes: integrating one or more arrays of memory-computing integrated cells of the memory-computing integrated chip to a plurality of first chips, wherein the one or more arrays of memory-computing integrated cells are used for computing with received data; integrating one or more peripheral circuit **IP** cores of the memory-computing integrated chip to one or more second chips; and packaging the plurality of first chips and the one or more second chips, wherein the one or more arrays of memory-computing integrated cells are coupled to the one or more peripheral circuit **IP** cores via one or more communication paths, and the one or more communication paths are arranged based on one or more of an operation property and an arrangement of the one or more arrays of memory-computing integrated cells of the plurality of first chips.

According to a third aspect of the present disclosure, an apparatus is provided. The apparatus includes the memory-computing integrated chip architecture described above.

According to one or more embodiments of the present disclosure, by determining the operation property and/or the arrangement of the arrays of memory-computing integrated cells of the plurality of first chips, the vertical scalability of the memory-computing integrated chip architecture may be fully utilized, and more flexible configuration of the communication path between the chip where the arrays of memory-computing integrated cells are located and the chip where the peripheral circuit **IP** core is located is allowed according to actual computing power requirements, thereby maximizing the use of the computing power of the arrays of memory-computing integrated cells, reducing the power consumption, and avoiding an over-disorderly arrangement of the communication paths.

These and other aspects of the present disclosure will be apparent from the embodiments described below, and will be clarified with reference to the embodiments described below.

### BRIEF DESCRIPTION OF THE DRAWINGS

More details, features, and advantages of the present disclosure are disclosed in the following description of example embodiments with reference to the accompanying drawings, in which:
FIG. 1 is a schematic diagram of a memory-computing integrated chip architecture according to some embodiments of the present disclosure;
FIG. 2 is a schematic diagram of a memory-computing integrated chip architecture according to some other embodiments of the present disclosure;
FIG. 3 is a schematic diagram of a memory-computing integrated chip architecture according to still some other embodiments of the present disclosure;
FIG. 4 is a schematic diagram of a memory-computing integrated chip architecture according to still some other embodiments of the present disclosure; and
FIG. 5 is a flowchart of a packaging method for a memory-computing integrated chip according to some embodiments of the present disclosure.

### DETAILED DESCRIPTION OF EMBODIMENTS

It is noted that although terms such as first, second and third may be used herein to describe various elements, components, areas, layers and/or parts, these elements, components, areas, layers and/or parts should not be limited by these terms. These terms are merely used to distinguish an element, component, area, layer or part from another element, component, area, layer or part. Therefore, a first element, component, area, layer or part discussed below may be referred to as a second element, component, area, layer or part without departing from the teaching of the present disclosure.

Terms regarding spatial relativity such as "under", "below", "lower", "beneath", "above" and "upper" may be used herein to describe the relationship between an element or feature and another element(s) or feature(s) as illustrated in the figures. It is noted that these terms are intended to cover different orientations of a device in use or operation in addition to the orientations depicted in the figures. For example, if the device in the figures is turned over, an element described as being "below another element or feature" or "under another element or feature" or "beneath another element or feature" will be oriented to be "above another element or feature". Thus, the example terms "below" and "beneath" may cover both orientations "above" and "below". Terms such as "before" or "ahead" and "after" or "then" may similarly be used. The device may be oriented in other ways (rotated by 90° or in other orientations), and the spatially relative descriptors used herein are interpreted correspondingly. In addition, it will also be understood that when a layer is referred to as being "between two layers", it may be the only layer between the two layers, or there may also be one or more intermediate layers.

The terms used herein are merely for the purpose of describing specific embodiments and are not intended to limit the present disclosure. As used herein, the singular forms "a", "an", and "the" are intended to include plural forms as well, unless otherwise explicitly indicated in the context. Further, it is noted that the terms "comprise" and/or "include", when used in the description, specify the presence of described features, entireties, steps, operations, elements and/or components, but do not exclude the presence or addition of one or more other features, entireties, steps, operations, elements, components and/or groups thereof. As used herein, the term "and/or" includes any and all combinations of one or more of the associated listed items, and the phrase "at least one of A and B" refers to only A, only B, or both A and B.

It is noted that when an element or a layer is referred to as being "on another element or layer", "connected to another element or layer", "coupled to another element or layer", or "adjacent to another element or layer", the element or layer may be directly on another element or layer, directly connected to another element or layer, directly coupled to another element or layer, or directly adjacent to another element or layer, or there may be an intermediate element or layer. On the contrary, when an element is referred to as being "directly on another element or layer", "directly connected to another element or layer", "directly coupled to another element or layer", or "directly adjacent to another element or layer", there is no intermediate element or layer. However, under no circumstances should "on" or "directly on" be interpreted as requiring a layer to completely cover the underlying layer.

Embodiments of the present disclosure are described herein with reference to schematic illustrations (and intermediate structures) of embodiments of the present disclosure. On this basis, variations in an illustrated shape, for example as a result of manufacturing techniques and/or tolerances, should be expected. Therefore, the embodiments of the present disclosure should not be interpreted as being limited to a specific shape of an area illustrated herein, but should comprise shape deviations caused due to manufacturing, for example. Therefore, the area illustrated in a figure is schematic, and the shape thereof is neither intended to illustrate the actual shape of the area of a device, nor to limit the scope of the present disclosure.

Unless otherwise defined, terms (including technical and scientific terms) used herein have the same meanings as commonly understood by those of ordinary skill in the art to which the present disclosure belongs. It is further noted that the terms such as those defined in dictionaries should be interpreted as having meanings consistent with the meanings thereof in relevant fields and/or in the context of the description, and will not be interpreted in an ideal or too formal sense, unless defined explicitly herein.

The von Neumann architecture on which computers typically operate includes two separate parts, namely, a memory and a processor. When instructions are executed, data needs to be written to the memory, instructions and data are read from the memory in sequence by the processor, and finally execution results are written back to the memory. Accordingly, data is frequently transmitted between the processor and the memory. If a transmission speed of the memory cannot match an operating speed of the processor, a computing capability of the processor may be limited, and thus performance of an entire computing system is reduced.

To improve the computing capability of the processor and alleviate the above problem, memory-computing integrated chips have been rapidly developed. Such chips have a computing unit with computing capability embedded into a memory. Both data computation and data storage are implemented in a memory-computing integrated chip by controlling an operating mode of the memory-computing integrated chip. Since frequently data transmission between the processor and the memory is reduced, data transmission latency and power consumption can be reduced, and performance of an entire computing system can be improved.

It is noticed that in the present disclosure, such a memory-computing integrated chip usually include a computing unit with a computing function, a unit for processing and storing computed data, etc. Currently, such a memory-computing integrated is mainly integrated by integrating the computing unit and another unit into different chips. However, the computing capability of such memory-computing integrated chip is limited and may not meet computing power requirement for large-scale AI algorithm model and variability of an architecture. In addition, blindly increasing of computing units to the memory-computing integrated chip to meet the computing power requirement may lead to a disorderly arrangement of communication paths between different chips, which increases a error rate and cost of the memory-computing integrated chip.

In view of the above technical problems, one or more embodiments of the present disclosure provide a memory-computing integrated chip architecture, a packaging method and apparatus for a memory-computing integrated chip. Various embodiments of the present disclosure are described in detail below in conjunction with the drawings.

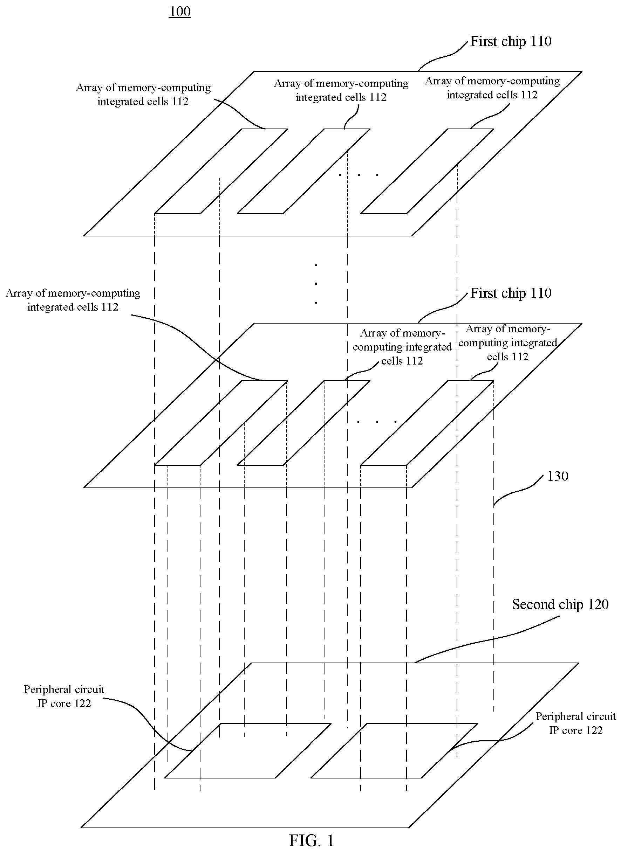

FIG. 1 illustrates a schematic diagram of a memory-computing integrated chip architecture 100 according to some embodiments of the present disclosure. As shown in FIG. 1, the memory-computing integrated chip architecture 100 may include: a plurality of first chips 110, each integrated with one or more arrays of memory-computing integrated cells 112, wherein the one or more arrays of memory-computing integrated cells are used for computing with received data; and one or more second chips 120, each integrated with one or more peripheral circuit IP cores 122, wherein the one or more arrays of memory-computing integrated cells 112 are coupled to the one or more peripheral circuit IP cores 122 via one or more communication paths 130, and the one or more communication paths 130 are arranged based on one or more of an operation property and an arrangement of the one or more arrays of memory-computing integrated cells 112 of the plurality of first chips 110.

The memory-computing integrated chip architecture may refer to a memory-computing integrated chip interconnection integrated structure, or a memory-computing integrated chip product, etc.

According to one or more embodiments of the present disclosure, by determining the operation property and/or the arrangement of the arrays of memory-computing integrated cells of the plurality of first chips, the vertical scalability of the memory-computing integrated chip architecture may be fully utilized, and more flexible configuration of the communication path between the chip where the arrays of memory-computing integrated cells are located and the chip where the peripheral circuit IP core is located is allowed according to actual computing power requirements, thereby maximizing the use of the computing power of the arrays of memory-computing integrated cells, reducing the power consumption, and avoiding an over-disorderly arrangement of the communication paths.

According to some embodiments of the present disclosure, the arrays of memory-computing integrated cells 112 of the first chip 110 may be implemented based on an analog circuit, that is, used for computing with the received analog data, e.g., for computing with a voltage and a current according to Kirchhoff's law or Ohm's law, for performing various addition operations, multiplication operations, matrix multiplication operations, etc according to Kirchhoff's law or Ohm's law. Or the arrays of memory-computing integrated cells 112 of the first chip 110 may be implemented based on a digital circuit. Although FIG. 1 shows two first chips, the memory-computing integrated chip architecture may include any suitable quantity of the plurality of first chips. For example, the quantity of first chips may be determined based on actual requirements such as matrix computing requirements, load application requirements, total algorithm capacity, or the like. Moreover, although FIG. 1 shows three arrays of memory-computing integrated cells of the first chip, each first chip may include any suitable quantity of arrays of memory-computing integrated cells. The scope of protection of the present disclosure is not limited in this respect.

According to some embodiments of the present disclosure, the one or more peripheral circuit **IP** cores integrated on the second chip may be a functional module based on an analog signal. **In** some examples, the one or more peripheral circuit **IP** cores may include one or more of: a programming circuit module coupled to the one or more arrays of memory-computing integrated cells and configured to perform data programming on the one or more arrays of memory-computing integrated cells; a digital-to-analog conversion module coupled to the one or more arrays of memory-computing integrated cells and configured to convert digital data to be input to the one or more arrays of memory-computing integrated cells into analog data; an analog-to-digital conversion module coupled to the one or more arrays of memory-computing integrated cells and configured to convert analog data, that is obtained through computing by the one or more arrays of memory-computing integrated cells, into digital data; a phase-locked loop; and an oscillator; a sense amplifier; a temperature sensor; and a power supply.

**In** some other examples, the one or more peripheral circuit **IP** cores may further include, for example, an input interface module, an input register file, an output register file, and an output interface module, or the like.

**In** still some other examples, the one or more peripheral circuit **IP** cores may further include a calibration module for calibrating data obtained by the one or more arrays of memory-computing integrated cells; and a compensation module for performing signal compensation on the data obtained by the one or more arrays of memory-computing integrated cells. The use of the calibration module and the compensation module may further increase chip reliability, thereby effectively mitigating interference of transmission via an analog signal between chips.

Although FIG. 1 shows one second chip, the memory-computing integrated chip architecture may include any suitable quantity of second chips to adapt to a computing capability of the arrays of memory-computing integrated cells of the first chips. Moreover, each second chip may have any quantity of peripheral circuit **IP** cores integrated thereon.

According to some embodiments of the present disclosure, the communication path between the array of memory-computing integrated cells and the peripheral circuit **IP** core may be any suitable interconnection component. For example, the interconnection component may include a metal pin of the first chip and the second chip. According to some other embodiments of the present disclosure, the communication path between the array of memory-computing integrated cells and the peripheral circuit **IP** core may include a bus, via which a signal is transmitted between the first chip and the second chip. According to still some other embodiments of the present disclosure, the communication path between the array of memory-computing integrated cells and the peripheral circuit **IP** core may include a through-silicon via (TSV) structure. According to still some other embodiments of the present disclosure, the communication path between the array of memory-computing integrated cells and the peripheral circuit IP core may include a hybrid bonding structure.

The communication path between the array of memory-computing integrated cells and the peripheral circuit **IP** core may be any combination of the components in the above embodiments. For example, a chip arranged at an uppermost layer or a chip arranged at a lowermost layer may be coupled through the hybrid bonding structure, and chips arranged at middle layers may be coupled to each other via the TSV structure.

According to some embodiments of the present disclosure, arranging the one or more communication paths based on one or more of the operation property and the arrangement of the one or more arrays of memory-computing integrated cells of the plurality of first chips may include: determining a position of each of the one or more arrays of memory-computing integrated cells at a corresponding first chip; and arranging the one or more communication paths based on the position, so that arrays of memory-computing integrated cells of the one or more arrays of memory-computing integrated cells that are located at a same corresponding position at the corresponding first chips share a same communication path.

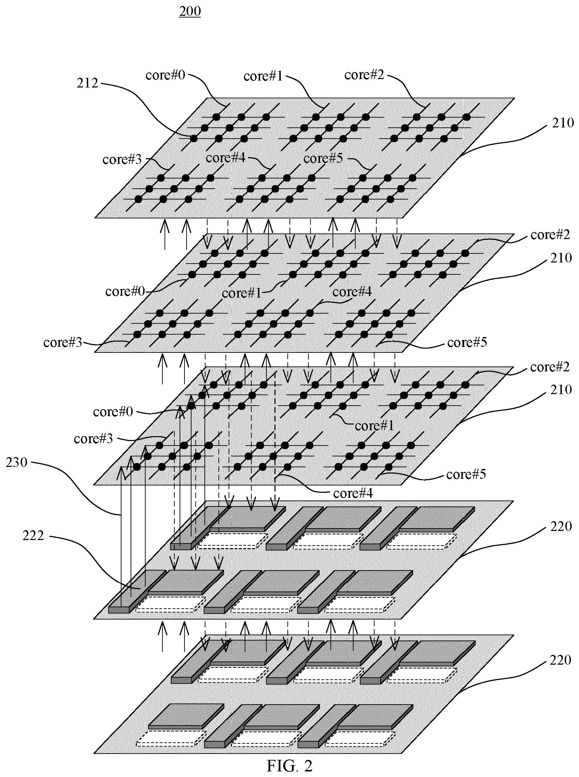

It is described below how to arrange the communication path between the first chip and the second chip in these embodiments with reference to FIG. 2. FIG. 2 illustrates a schematic diagram of a memory-computing integrated chip architecture 200 according to some other embodiments of the present disclosure. The memory-computing integrated chip architecture 200 may include a plurality of first chips 210 similar to those in FIG. 1, each integrated with an array of memory-computing integrated cells 212; and one or more second chips 220 similar to those in FIG. 1, each integrated with one or more peripheral circuit **IP** cores 222, wherein the array of memory-computing integrated cells 212 is coupled to the one or more peripheral circuit **IP** cores 222 via one or more communication paths 230.

According to some embodiments of the present disclosure, the arrays of memory-computing integrated cells of different first chips may operate in parallel at the same time. In this case, arranging the one or more communication paths based on one or more of the operation property and the arrangement of the one or more arrays of memory-computing integrated cells of the plurality of first chips may include: numbering each of the one or more arrays of memory-computing integrated cells of the plurality of first chips.

In some examples, arrays of memory-computing integrated cells at the same corresponding position of the first chips may be numbered the same and a number mapping relationship may be formed. As shown, arrays of memory-computing integrated cells of the first chip at an uppermost layer may be numbered 0 to 5 in sequence, and arrays of memory-computing integrated cells of the first chips at second and third layers may also be numbered 0 to 5 in sequence, so that the arrays of memory-computing integrated cells at the same position at the first chips have a same number. In this case, the number mapping relationship includes: 0-0-0, 1-1-1, 2-2-2, 3-3-3, 4-4-4, and 5-5-5.

In some other examples, the arrays of memory-computing integrated cells at the same corresponding position of different first chips may be numbered differently and a number mapping relationship may be formed. For example (not shown), arrays of memory-computing integrated cells of the first chip at an uppermost layer may be numbered 0 to 5 in sequence, and arrays of memory-computing integrated cells of the first chips at the second and third layers may be respectively numbered 6 to 11 and 12 to 17 in sequence. In this case, the number mapping relationship includes: 0-6-12, 1-7-13, 2-8-14, 3-9-15, 4-10-16, and 5-11-17.

In this case, the arrays of memory-computing integrated cells may be assigned any number, as long as a mapping relationship can be formed for the arrays of memory-computing integrated cells at the same corresponding position of the first chips.

Continuing with the embodiments, arranging the one or more communication paths based on one or more of the operation property and the arrangement of the one or more arrays of memory-computing integrated cells of the plurality of first chips may further include: numbering each of the one or more peripheral circuit IP cores of the second chip.

In some examples, the peripheral circuit IP core of the second chip may be numbered correspondingly according to the number mapping relationship of the arrays of memory-computing integrated cells of the first chips. For example, in the case that the number mapping relationship includes 0-0-0, 1-1-1, 2-2-2, 3-3-3, 4-4-4, and 5-5-5, the peripheral circuit IP cores of the second chip may be numbered 0 to 5 in sequence, so that the array of memory-computing integrated cells of the first chip and the peripheral circuit IP core of the second chip at a corresponding position have a same number. For another example, in the case that the number mapping relationship includes 0-6-12, 1-7-13, 2-8-14, 3-9-15, 4-10-16, and 5-11-17, the peripheral circuit IP cores on the second chip may be numbered 0 to 5 in sequence, so that the arrays of memory-computing integrated cells numbered 0, 6, and 12 correspond to the peripheral circuit IP core numbered 0, the arrays of memory-computing integrated cells numbered 1, 7, and 13 correspond to the peripheral circuit IP core numbered 1, and so on.

Continuing with the embodiments, arranging the one or more communication paths based on one or more of the operation property and the arrangement of the one or more arrays of memory-computing integrated cells of the plurality of first chips may further include: arranging the one or more communication paths based on the numbered arrays of memory-computing integrated cells and the numbered peripheral circuit IP cores.

In some examples, a same communication path may be arranged between the arrays of memory-computing integrated cells that are with a same number and of different first chips, so that the arrays of memory-computing integrated cells with the same number share a same input from the second chip. For example, three arrays of memory-computing integrated cells that are numbered 0 and of three first chips are arranged in parallel and share a same input. Then, the same communication path between the arrays of memory-computing integrated cells with the same number may be extended and connected to the peripheral circuit IP core with a corresponding number of the second chip. For example, a communication path is formed among three arrays of memory-computing integrated cells numbered 0 of three first chips and the peripheral circuit IP core numbered 0 of the second chip.

In some examples, after each array of memory-computing integrated cells receives an input from a corresponding peripheral circuit IP core and performs matrix computation, an output may be provided to the corresponding peripheral circuit IP core. In some other examples, each array of memory-computing integrated cells receives an input from a corresponding peripheral circuit IP core and perform matrix computation, and then outputs may be parallelly connected to be provided to the corresponding peripheral circuit IP cores. The scope of protection of the present disclosure is not limited in this respect.

With such an arrangement, vertical scalability of 3D packaging can be fully utilized, and computing speed is improved, meanwhile computing power requirement of the first chip is satisfied. For example, in a case where the array of memory-computing integrated cells of each first chip performs a matrix computation of vectors 2k*2k, a matrix computation of a vector 2k and a vector 2k*2nk may be implemented by using the above arrangement of the communication paths (where n is a quantity of first chips), thereby achieving hardware acceleration in an operation of multiplying a vector by a matrix.

According to some embodiments of the present disclosure, arranging the one or more communication paths based on one or more of the operation property and the arrangement of the one or more arrays of memory-computing integrated cells of the plurality of first chips may include: determining an operation state of each of the one or more arrays of memory-computing integrated cells, wherein the operation state may include an enabled operation state and a disabled operation state; and arranging the one or more communication paths based on the operation state, so that each array of memory-computing integrated cells in the enabled operation state is coupled to a corresponding peripheral circuit IP core of the one or more peripheral circuit IP cores via a distinct communication path.

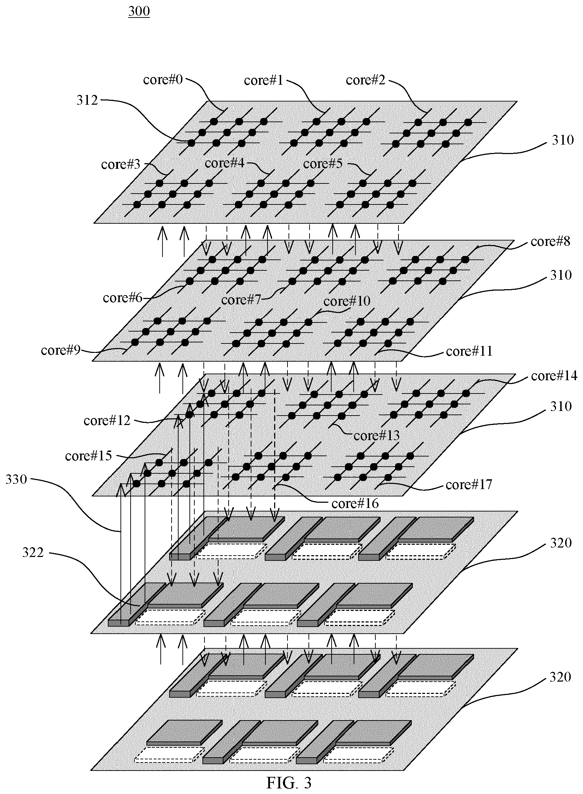

It is described below how to arrange the communication paths between a first chip and a second chip in these embodiments with reference to FIG. 3. FIG. 3 illustrates a schematic diagram of a memory-computing integrated chip architecture 300 according to still some other embodiments of the present disclosure. The memory-computing integrated chip architecture 300 may include a plurality of first chips 310 similar to those in FIG. 1 and FIG. 2, and one or more second chips 320 similar to those in FIG. 1 and FIG. 2, each first chip is integrated with arrays of memory-computing integrated cells 312; each second chip is integrated with one or more peripheral circuit IP cores 322, wherein the arrays of memory-computing integrated cells 312 are coupled to one or more peripheral circuit IP cores 322 via one or more communication paths 330.

According to some embodiments of the present disclosure, a part of the arrays of memory-computing integrated cells of the first chips may be in the enabled operation state, and another part of the arrays of memory-computing integrated cells may be in the disabled operation state. The array of memory-computing integrated cells in the enabled operation state may perform an operation such as matrix computation or the like, while the array of memory-computing integrated cells in the disabled operation state does not perform any operation. In this case, the one or more communication paths may be arranged based on information about whether each array of memory-computing integrated cell is in the enabled operation state.

Accordingly, similar to the above embodiments regarding the arrays of memory-computing integrated cells that may operate in parallel at the same time, arranging the one or more communication paths based on one or more of the operation property and the arrangement of the one or more arrays of memory-computing integrated cells of the plurality of first chips may include: numbering each of the one or more arrays of memory-computing integrated cells of the plurality of first chips. In some examples, all arrays of memory-computing integrated cells of each first chip may be numbered differently in sequence. As shown, arrays of memory-computing integrated cells of the first chip at the uppermost layer may be numbered 0 to 5 in sequence, and arrays of memory-computing integrated cells of the first chips at the second and third layers may be respectively numbered 6 to 11 and 12 to 17 in sequence. The arrays of memory-computing integrated cells numbered 0, 4, 7, 8, 11, 12, and 15 are in the enabled operation state.

Continuing with the embodiments, similarly, arranging the one or more communication paths based on one or more of the operation property and the arrangement of the one or more arrays of memory-computing integrated cells of the plurality of first chips may further include: numbering each of the one or more peripheral circuit IP cores of the second chip. In some examples, the peripheral circuit IP cores of the second chip may be numbered correspondingly according to the numbers of the arrays of memory-computing integrated cells of the first chips. For example, in the case that the arrays of memory-computing integrated cells are differently numbered 0 to 5, 6 to 11, and 12 to 17 in sequence, the peripheral circuit IP cores of the second chip may be correspondingly differently numbered 0 to 17 in sequence, so that each array of memory-computing integrated cells corresponds to a peripheral circuit IP core with a same number.

Continuing with the embodiments, similarly, arranging the one or more communication paths based on one or more of the operation property and the arrangement of the one or more arrays of memory-computing integrated cells of the plurality of first chips may further include: arranging the one or more communication paths based on the numbered arrays of memory-computing integrated cells and the numbered peripheral circuit IP cores. In some examples, a communication path may be formed between each array of memory-computing integrated cell in the enabled operation state of the first chip and the peripheral circuit IP core of the second chip with a corresponding number. For example, communication paths are formed between the arrays of memory-computing integrated cells numbered 0, 4, 7, 8, 11, 12, and 15 in the enabled operation state and the peripheral circuit IP cores numbered 0, 4, 7, 8, 11, 12, and 15 of the second chip, respectively.

In this case, each array of memory-computing integrated cells in the enabled operation state receives an input from a distinct corresponding peripheral circuit IP core to perform an operation such as matrix computation or the like, and then an output is provided to a corresponding peripheral circuit IP core.

With such an arrangement, a communication path is provided to the array of memory-computing integrated cells in the enabled operation state but not to the array of memory-computing integrated cells in the disabled operation state, thereby simplifying arrangement of communication paths, and effectively avoiding mutual interference between input signals to the arrays of memory-computing integrated cells of different first chips, which facilitates to improving computation accuracy of the chips.

According to some embodiments of the present disclosure, arranging the one or more communication paths based on one or more of the operation property and the arrangement of the one or more arrays of memory-computing integrated cells of the plurality of first chips may include: determining a position of each of the one or more arrays of memory-computing integrated cells at a corresponding first chip; determining an operation state of each of the one or more arrays of memory-computing integrated cells, wherein the operation state may include an enabled operation state and a disabled operation state; and arranging the one or more communication paths based on the position and the operation state, so that: arrays of memory-computing integrated cells of the one or more arrays of memory-computing integrated cells that are located at a same corresponding positions at corresponding first chips and that are in the enabled operation state share a same communication path; and arrays of memory-computing integrated cells of the one or more arrays of memory-computing integrated cells that are located at different corresponding positions at corresponding first chips and/or that are in the disabled operation state are coupled to corresponding peripheral circuit **IP** cores of the one or more peripheral circuit IP cores via a distinct communication path.

According to some embodiments of the present disclosure, there may be a situation that arrays of memory-computing integrated cells in the enabled operation state are distributed at corresponding positions of different first chips. In this case, by establishing a same shared communication path for the arrays of memory-computing integrated cells that are located at a same corresponding position and that are in the enabled operation state, and establishing different communication paths for arrays of memory-computing integrated cells that are located at different corresponding positions and/or that are in the disabled operation state, thereby vertical scalability of 3D packaging, improvement of chip computing speed, and anti-interference capability between arrays of memory-computing integrated cells can be balanced.

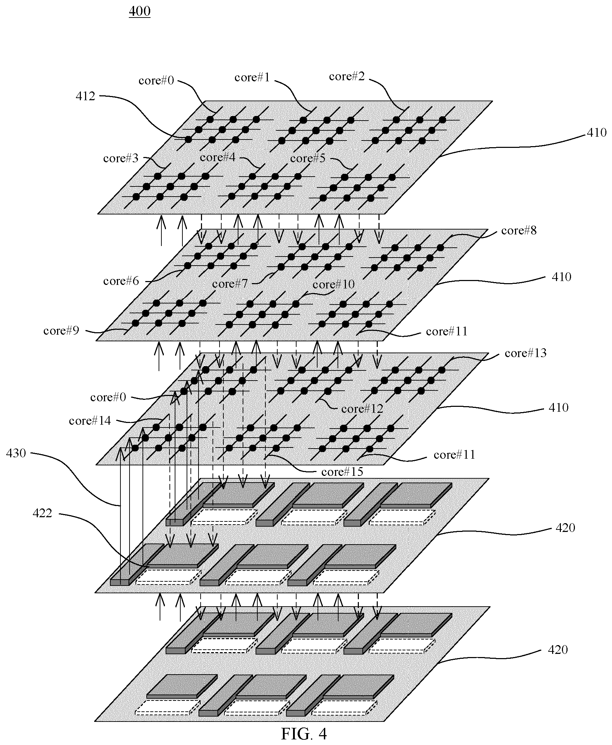

It is described below how to arrange a communication path between a first chip and a second chip in these embodiments with reference to FIG. 4. FIG. 4 illustrates a schematic diagram of a memory-computing integrated chip architecture 400 according to still some other embodiments of the present disclosure. The memory-computing integrated chip architecture 400 may include a plurality of first chips 410 similar to those in FIG. 1 to FIG. 3, and one or more second chips 420 similar to those in FIG. 1 to FIG. 3; each first chip is integrated with arrays of memory-computing integrated cells 412, and each second chip is integrated with one or more peripheral circuit IP cores 422, wherein the arrays of computing-in-memory cells 412 are coupled to one or more peripheral circuit IP cores 422 via one or more communication paths 430.

According to some embodiments of the present disclosure, according to load application requirement and matrix computation requirement, there may be a situation that arrays of memory-computing integrated cells in the enabled operation state are distributed at corresponding positions of different first chips. In this case, one or more communication paths may be arranged based on both whether each array of memory-computing integrated cells is in the enabled operation state and a position of each array of memory-computing integrated cells at the first chip.

Correspondingly, similar to the embodiments mentioned above, arranging the one or more communication paths based on one or more of the operation property and the arrangement of the one or more arrays of memory-computing integrated cells of the plurality of first chips may include: numbering each of the one or more arrays of memory-computing integrated cells of the plurality of first chips. In some examples, arrays of memory-computing integrated cells that are located at a same corresponding position of the first chips and that are in the enabled operation state may be numbered the same and a number mapping relationship may be formed, and the remaining arrays of memory-computing integrated cells (that are in the disabled operation state or that are located at different positions of the first chips) may be numbered differently in sequence. As shown, arrays of memory-computing integrated cells of the first chip at the uppermost layer may be numbered 0 to 5 in sequence, wherein the arrays of memory-computing integrated cells numbered 0 and 4 are in the enabled operation state. Arrays of memory-computing integrated cells of the first chip at the second layer may be numbered 6 to 11 in sequence according to their operation states, wherein the arrays of memory-computing integrated cells numbered 7, 8, and 11 are in the enabled operation state. Arrays of memory-computing integrated cells of the first chip at the third layer may be numbered 0, 12, 13, 14, 15, and 11 in sequence according to their operation states, wherein the arrays of memory-computing integrated cells numbered 0, 14, and 11 are in the enabled operation state, the array of memory-computing integrated cell numbered 0 of the first chip at the third layer and the array of memory-computing integrated cell numbered 0 of the first chip at the first layer have a same corresponding position, and the array of memory-computing integrated cell numbered 11 of the first chip at the third layer and the array of memory-computing integrated cell numbered 11 of the first chip at the second layer have a same corresponding position.

Continuing with the embodiments, similarly, arranging the one or more communication paths based on one or more of the operation property and the arrangement of the one or more arrays of memory-computing integrated cells of the plurality of first chips may further include: numbering each of the one or more peripheral circuit IP cores of the second chip. In some examples, the peripheral circuit IP cores of the second chip may be numbered correspondingly according to the numbers of the arrays of memory-computing integrated cells of the first chips. For example, in the case that the arrays of memory-computing integrated cells are differently numbered 0 to 5 (the first chip at the first layer), 6 to 11 (the first chip at the second layer), and 0, 12, 13, 14, 15 and 11 (the first chip at the third layer) in sequence, the peripheral circuit IP cores of the second chip may be differently numbered 0 to 15 in sequence, so that each array of memory-computing integrated cells corresponds to a peripheral circuit IP core with a same number.

Continuing with the embodiments, similarly, arranging the one or more communication paths based on one or more of the operation property and the arrangement of the one or more arrays of memory-computing integrated cells of the plurality of first chips may further include: arranging the one or more communication paths based on the numbered arrays of memory-computing integrated cells and the numbered peripheral circuit IP cores.

In some examples, a same communication path may be arranged for arrays, with a same number, of memory-computing integrated cells of different first chips, so that the arrays of memory-computing integrated cells with the same number share a same input from the second chip. For example, the array of memory-computing integrated cells numbered 0 of the first chip at the first layer and the array of memory-computing integrated cells numbered 0 of the first chip at the third layer are arranged in parallel to each other and share a same input; and the array of memory-computing integrated cells numbered 11 of the first chip at the second layer and the array of memory-computing integrated cells numbered 11 of the of first chip at the third layer are arranged in parallel to each other and share a same input. Then, a same communication path for arrays of memory-computing integrated cells with a same number may be extended and connected to a peripheral circuit IP core with a corresponding number of the second chip. For example, a communication path is formed among the array of memory-computing integrated cells numbered 0 of the first chip at the first layer, the array of memory-computing integrated cells numbered 0 of the first chip at the third layer, and the peripheral circuit IP core numbered 0 of the second chip, and a communication path is formed among the array of memory-computing integrated cells numbered 11 of the first chip at the second layer, the array of memory-computing integrated cells numbered 11 of the first chip at the third layer, and the peripheral circuit IP core numbered 11 of the second chip. Accordingly, such arrays of memory-computing integrated cells receive inputs from corresponding peripheral circuit IP cores and perform matrix computation, and then provide outputs to the corresponding peripheral circuit IP cores, respectively, or the outputs are parallelly connected and then provided to the corresponding peripheral circuit IP cores.

Continuing with the example, a communication path may be formed between an array of memory-computing integrated cells and a peripheral circuit IP core with a same corresponding number. Different communication paths may be formed for arrays of memory-computing integrated chip cells with different numbers. For example, a communication path is formed between the array of memory-computing integrated cell numbered 1 and the peripheral circuit IP core numbered 1, another communication path is formed between the array of memory-computing integrated cell numbered 2 and the peripheral circuit IP core numbered 2, and so on. Accordingly, such arrays of memory-computing integrated cells receive inputs from different corresponding peripheral circuit IP cores to perform operations such as matrix computation or the like, and then outputs are provided to the corresponding peripheral circuit IP cores, respectively.

With such an arrangement, a same shared communication path is established for the arrays of memory-computing integrated cells at a same corresponding position and in the enabled operation state, and different communication paths are established for the arrays of memory-computing integrated cells at different corresponding positions and/or in the disabled operation state, which may balance vertical scalability of 3D packaging, chip computing speed, and anti-interference between arrays of memory-computing integrated cells, thereby maximizing use of chip computing power and reducing power consumption and cost.

According to some embodiments of the present disclosure, a quantity of second chips may be one. For example, in any embodiment described above, it is possible to provide only one second chip. Therefore, details are not described herein again.

According to some other embodiments of the present disclosure, a quantity of second chips may be greater than 1 and less than a quantity of the plurality of the first chips.

For example, in the embodiments described above with reference to FIG. 3, two second chips may be provided which are integrated with peripheral circuit IP cores, and a quantity of the peripheral circuit IP cores are corresponding to a quantity of arrays of memory-computing integrated cells of the first chip (for example, each second chip is integrated with nine peripheral circuit IP cores). Then, a communication path may be established between an array of memory-computing integrated cells and a peripheral circuit IP core with a same corresponding number according to an operation state of the array of memory-computing integrated cells of the first chips.

For another example, in the embodiments described above with reference to FIG. 4, two second chips may be provided, wherein one second chip is integrated with one or more corresponding peripheral circuit IP cores that provide inputs to one or more groups of arrays of memory-computing integrated cells in the enabled operation state and at a same corresponding position and receive outputs from the one or more groups of arrays of memory-computing integrated cells, andthe other second chip is integrated with one or more corresponding peripheral circuit IP cores that provide inputs to other arrays of memory-computing integrated cells and receive outputs from these arrays of memory-computing integrated cells. It should be understood that it is illustrated how to integrate the one or more peripheral circuit IP cores to the two second chips for illustrative purposes, and other integration implementations can be used to integrate the one or more peripheral circuit IP cores to the two second chips. For example, continuing with the above example, the peripheral circuit IP cores numbered 0 to 8 may be integrated to one second chip, and the peripheral circuit IP cores numbered 9 to 15 may be integrated to the other second chip.

By providing a plurality of second chips with a quantity greater than 1 and less than a quantity of the first chips, more flexible configurations of second chips and peripheral circuit IP cores integrated therewith may be allowed according to requirement of an algorithm executed on a chip, thereby avoiding an increase in cost due to providing a redundant second chip or integrating a redundant peripheral circuit IP core.

According to still some other embodiments of the present disclosure, a quantity number of second chips may be the same as a quantity of the plurality of first chips, so that each of the plurality of first chips corresponds to one second chip; and one or more communication paths may be arranged between each first chip and the corresponding second chip, so that each array of memory-computing integrated cells of each first chip is communicatively coupled to the corresponding peripheral circuit IP core of the second chip corresponding to the first chip.

For example, in the embodiments described above with reference to FIG. 3, three second chips may be provided, so that each second chip corresponds to one first chip, and a communication path is arranged between the first chip and the second chip. In this case, each second chip may be integrated with peripheral circuit IP cores with a quantity same as a quantity of the arrays of memory-computing integrated cells of the corresponding first chip, thereby avoiding mutual interference during data transmission between chips as much as possible.

For another example, in the embodiments described above with reference to FIG. 4, three second chips may be provided, so that each second chip corresponds to one first chip, and a communication path is arranged between the first chip and the second chip. In this case, a peripheral circuit IP core of a second chip at a certain layer may be defaulted since a communication path is shared by one or more groups of arrays of memory-computing integrated cells that are in the enabled operation state and located at a same corresponding position of first chips. For example, as shown in FIG. 4, the array of memory-computing integrated cells numbered 0 of the first chip at the first layer and the array of memory-computing integrated cells numbered 0 of the first chip at the third layer share a same communication path. Therefore, a peripheral circuit IP core may not be integrated at a position corresponding the first chip at the first layer or the first chip at the third layer, thereby reducing complexity of manufacturing the second chip and saving cost.

According to some embodiments of the present disclosure, in the case that a quantity of second chips is the same as a quantity of the plurality of first chips, the plurality of first chips and the second chips are arranged in a cross-stacked manner. For example, the memory-computing integrated chip architecture may be packaged in an order of one first chip and then one second chip, and so on. In this way, the communication paths between the first chips and the second chips can be shortened, which results in a simpler arrangement of the communication paths and effectively avoids a disorderly arrangement of the communication paths.

According to some other embodiments of the present disclosure, in a case that a quantity of second chips is the same as a quantity of the plurality of first chips, the plurality of first chips are arranged above or below the second chips. For example, the memory-computing integrated chip architecture may be packaged in an order of three first chips and then three second chips (it should be understood that the three first chips and the three second chips are merely used as an example herein, and the quantity of first chips and that of second chips is not limited). In this way, process complexity for packaging the memory-computing integrated chip architecture can be reduced to some extent. This is because different process nodes may be used to integrate the arrays of memory-computing integrated cells and the peripheral circuit IP core to the first chip and the second chip, respectively. In this case, packaging the first chips using a same process node together or second chips using a same process node together can reduce complexity of packaging process.

The order in which the first chips and the second chips are stacked may be any other suitable order according to a packaging process and requirement. For example, the memory-computing integrated chip architecture may be packaged in an order of two first chips, one second chip, one first chip, and then two second chips. For another example, the memory-computing integrated chip architecture may be packaged in an order of one first chip, two second chips, two first chips, and then one second chip.

According to some embodiments of the present disclosure, the memory-computing integrated chip architectures 100 to 400 described above with reference to FIGS. 1-4 may further include one or more third chips each integrated with one or more digital circuit IP cores.

According to some embodiments of the present disclosure, the digital circuit IP core of the third chip may be a functional module based on a digital signal. In some examples, the digital circuit IP core may include one or more of: a post-processing operation circuit configured to perform a post-processing operation on digital data converted by the analog-to-digital conversion module; a random-access memory (RAM); a central processing unit (CPU); a graphics processing unit (GPU); and a peripheral interface module.

In some examples, the post-processing operation may include operations such as shifting, activation, or the like.

The above implementation of the digital circuit IP core of the third chip in the memory-computing integrated chip architecture is shown merely for illustrative purposes. The digital circuit IP core may further include one or more other modules, such as a codec module or the like.

The digital circuit IP core of the third chip may be coupled to the array of memory-computing integrated cells of the first chip or the peripheral circuit IP core of the second chip in any suitable manner. The scope of protection of the present disclosure is not limited in this respect.

According to some embodiments of the present disclosure, the one or more arrays of memory-computing integrated cells may be integrated to the plurality of first chips through a first process node, and the peripheral circuit IP core may be integrated to the one or more second chips through a second process node different from the first process node.

In some examples, the arrays of memory-computing integrated cells may be implemented based on an analog circuit. Since an analog signal in an analog circuit is susceptible to noise interference, integration of the arrays of memory-computing integrated cells and the peripheral circuit IP core to different chips through different process nodes may effectively mitigate interference between these modules, and ensure accuracy and reliability of data. In addition, based on different implementations of the two types of circuits, more appropriate process nodes may be selected, thereby reducing process costs.

According to some embodiments of the present disclosure, the line width of the second process node for integrating the peripheral circuit IP core may be less than that of the first process node for integrating the one or more arrays of memory-computing integrated cells.

In some examples, the peripheral circuit IP core may be integrated to the one or more second chip through a process node with a line width of 14 nanometers (nm) or 7 nm.

In some other examples, the one or more arrays of memory-computing integrated cells may be integrated to the plurality of first chips through a process node with a line width of 55 nm, 40 nm, or 28 nm.

**In** general, an implementation of chip based on an analog circuit has a lower requirement for a process node, because use of an advanced process node with a smaller line width may cause distortion of an analog signal due to noise and reduce accuracy. By contrast, an implementation of chip based on a digital circuit has a higher requirement for a process node, so as to improve operating performance and a chip precision. Therefore, the use of the process node with a smaller line width to integrate the peripheral circuit **IP** core, and the use of the process node with a larger line width to integrate the arrays of one or more memory-computing integrated cells based on an analog circuit make it possible to avoid high cost, excessive power consumption, and potential data distortion resulting from both using the advanced process node with a smaller line width to integrate different chips, and to avoid low operating performance of chips resulting from both using the process node with a larger line width to integrate different chips. This allows for a trade-off among performance, power consumption, and cost.

According to some embodiments of the present disclosure, the one or more arrays of memory-computing integrated cells, and the peripheral circuit **IP** core may be integrated, through a same process node, to the plurality of first chips and the one or more second chips, respectively.

**In** this case, a more appropriate process node can be selected as needed. For example, when requirements for chip performance are not high and reduction of power consumption and cost is desired, a process node with a line width of 28 nm can be selected to integrate the one or more arrays of memory-computing integrated cells and the peripheral circuit **IP** core to the plurality of first chips and the one or more second chips, respectively. For another example, if higher chip performance is desired, a process node with a line width lower than 28 nm can be selected to integrate the one or more arrays of memory-computing integrated cells and the peripheral circuit **IP** core to the plurality of first chips and the one or more second chips, respectively.

The use of the same process node (that is, the same line width) to integrate different chips may simplify operations and complexity for integrating chips.

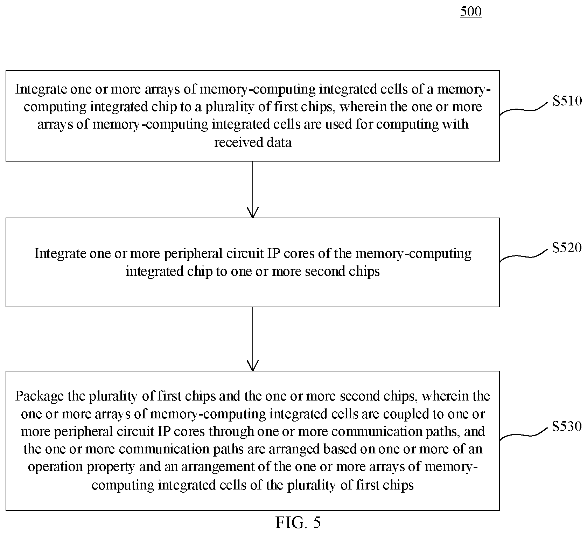

FIG. 5 illustrates a flowchart of a packaging method 500 for a memory-computing integrated chip according to some embodiments of the present disclosure. As shown in FIG. 5, the packaging method 500 may include: step S510: integrating one or more arrays of memory-computing integrated cells of the memory-computing integrated chip to a plurality of first chips, wherein the one or more arrays of memory-computing integrated cells are used for computing with received data; step S520: integrating one or more peripheral circuit **IP** cores of the memory-computing integrated chip to one or more second chips; and step S530: packaging the plurality of first chips and the one or more second chips, wherein the one or more arrays of memory-computing integrated cells are coupled to one or more peripheral circuit **IP** cores through one or more communication paths, and wherein the one or more communication paths are arranged based on one or more of an operation property and an arrangement of the one or more arrays of memory-computing integrated cells of the plurality of first chips.

According to one or more embodiments of the present disclosure, by determining the operation property and/or the arrangement of the arrays of memory-computing integrated cells of the plurality of first chips, the vertical scalability of the memory-computing integrated chip architecture may be fully utilized, and more flexible configuration of the communication path between the chip where the arrays of memory-computing integrated cells are located and the chip where the peripheral circuit **IP** core is located is allowed according to actual computing power requirements, thereby maximizing the use of the computing power of the arrays of memory-computing integrated cells, reducing the power consumption, and avoiding an over-disorderly arrangement of the communication paths.

According to one or more embodiments of the present disclosure, arranging the one or more communication paths based on one or more of the operation property and the arrangement of the one or more arrays of memory-computing integrated cells of the plurality of first chips may include: determining a position of each of the one or more arrays of memory-computing integrated cells at a corresponding first chip; and arranging the one or more communication paths based on the position, so that arrays of memory-computing integrated cells of the one or more arrays of memory-computing integrated cells that are located at a same corresponding position at corresponding first chips share a same communication path.

According to one or more embodiments of the present disclosure, arranging the one or more communication paths based on one or more of the operation property and the arrangement of the one or more arrays of memory-computing integrated cells of the plurality of first chips may include: determining an operation state of each of the one or more arrays of memory-computing integrated cells, wherein the operation state may include an enabled operation state and a disabled operation state; and arranging the one or more communication paths based on the operation state, so that each array of memory-computing integrated cells in the enabled operation state is coupled to a corresponding peripheral circuit **IP** core of the one or more peripheral circuit IP cores via a distinct communication path.

According to one or more embodiments of the present disclosure, arranging the one or more communication paths based on one or more of the operation property and the arrangement of the one or more arrays of memory-computing integrated cells of the plurality of first chips may include: determining a position of each of the one or more arrays of memory-computing integrated cells at a corresponding first chip; determining an operation state of each of the one or more arrays of memory-computing integrated cells, wherein the operation state includes an enabled operation state and a disabled operation state; and arranging the one or more communication paths based on the position and the operation state, so that: arrays of memory-computing integrated cells of the one or more arrays of memory-computing integrated cells that are located at a same corresponding position at corresponding first chips and that are in the enabled operation state share a same communication path; and arrays of memory-computing integrated cells of the one or more arrays of memory-computing integrated cells that are located at different corresponding positions at corresponding first chips and/or that are in the disabled operation state are each coupled to a corresponding peripheral circuit IP core of the one or more peripheral circuit IP cores via a distinct communication path.

According to one or more embodiments of the present disclosure, a quantity of second chips may be one, and arranging the one or more communication paths based on one or more of the operation property and the arrangement of the one or more arrays of memory-computing integrated cells of the plurality of first chips may include: numbering each of the one or more arrays of memory-computing integrated cells of the plurality of first chips; numbering each of the one or more peripheral circuit IP cores of the second chip; and arranging the one or more communication paths based on numbered arrays of memory-computing integrated cells and numbered peripheral circuit IP cores.

According to one or more embodiments of the present disclosure, a quantity of second chips may be greater than 1 and less than a quantity of the plurality of first chips.

According to one or more embodiments of the present disclosure, a quantity of second chips may be the same as a quantity of the plurality of first chips, so that each of the plurality of first chips corresponds to one second chip; and the one or more communication paths may be arranged between each first chip and the corresponding second chip, so that each array of memory-computing integrated cells of each first chip is communicatively coupled to a corresponding peripheral circuit **IP** core of the second chip corresponding to the first chip.

According to one or more embodiments of the present disclosure, the plurality of first chips and the second chips may be arranged in a cross-stacked manner; or the plurality of first chips may be arranged above or below the second chips.

According to one or more embodiments of the present disclosure, the packaging method 500 may further include: integrating one or more digital circuit IP cores of the memory-computing integrated chip to one or more third chips; and packaging the plurality of first chips, the one or more second chips, and the one or more third chips.

According to one or more embodiments of the present disclosure, the one or more arrays of memory-computing integrated cells may be integrated to the plurality of first chips through a first process node, and the peripheral circuit **IP** core may be integrated to the one or more second chips through a second process node different from the first process node.

According to one or more embodiments of the present disclosure, a line width of the second process node may be less than that of the first process node.

According to one or more embodiments of the present disclosure, the one or more arrays of memory-computing integrated cells and the peripheral circuit **IP** core are integrated to the plurality of first chips and the one or more second chips through a same process node, respectively.

According to one or more embodiments of the present disclosure, the one or more communication paths may include a through-silicon via (TSV) structure and/or a hybrid bonding structure.

According to one or more embodiments of the present disclosure, the one or more peripheral circuit **IP** cores may include one or more of: a programming circuit module coupled to the one or more arrays of memory-computing integrated cells and configured to perform data programming on the one or more arrays of memory-computing integrated cells; a digital-to-analog conversion module coupled to the one or more arrays of memory-computing integrated cells and configured to convert digital data to be input to the one or more arrays of memory-computing integrated cells into analog data; an analog-to-digital conversion module coupled to the one or more arrays of memory-computing integrated cells and configured to convert analog data obtained through computing by the one or more arrays of memory-computing integrated cells into digital data; a phase-locked loop; an oscillator; a sense amplifier; a temperature sensor; and a power supply.

According to one or more embodiments of the present disclosure, the digital circuit **IP** core may include one or more of: a post-processing operation circuit configured to perform a post-processing operation on digital data converted by the analog-to-digital conversion module; a random-access memory (RAM); a central processing unit (CPU); a graphics processing unit (GPU); and a peripheral interface module.

Each step of the packaging method 500 shown in FIG. 5 may correspond to a corresponding module in the memory-computing integrated chip architectures 100-400 described with reference to FIGS. 1-4. Therefore, the components, functions, features, and advantages described above for the memory-computing integrated chip architectures 100-400 are applicable to the packaging method 500 and the steps included therein. For the purpose of brevity, some operations, features, and advantages are not described herein.

According to another aspect of the present disclosure, an apparatus is provided, which includes the memory-computing integrated chip architecture described above.

Some exemplary aspects of the present disclosure are described below.

Aspect 1. A memory-computing integrated chip architecture, including:
a plurality of first chips each integrated with one or more arrays of memory-computing integrated cells, wherein the one or more arrays of memory-computing integrated cells are used for computing with received data; and
one or more second chips each integrated with one or more peripheral circuit **IP** cores,
wherein the one or more arrays of memory-computing integrated cells are coupled to the one or more peripheral circuit **IP** cores via one or more communication paths, and the one or more communication paths are arranged based on one or more of an operation property and an arrangement of the one or more arrays of memory-computing integrated cells of the plurality of first chips.

Aspect 2. The memory-computing integrated chip architecture according to aspect 1, wherein arranging the one or more communication paths based on one or more of the operation property and the arrangement of the one or more arrays of memory-computing integrated cells of the plurality of first chips includes:
determining a position of each of the one or more arrays of memory-computing integrated cells at a corresponding first chip; and
arranging the one or more communication paths based on the position, so that arrays of memory-computing integrated cells of the one or more arrays of memory-computing integrated cells that are located at a same corresponding position at corresponding first chips share a same communication path.

Aspect 3. The memory-computing integrated chip architecture according to aspect 1, wherein arranging the one or more communication paths based on one or more of the operation property and the arrangement of the one or more arrays of memory-computing integrated cells of the plurality of first chips includes:
determining an operation state of each of the one or more arrays of memory-computing integrated cells, wherein the operation state includes an enabled operation state and a disabled operation state; and
arranging the one or more communication paths based on the operation state, so that each array of memory-computing integrated cells in the enabled operation state is coupled to a corresponding peripheral circuit **IP** core of the one or more peripheral circuit **IP** cores via a distinct communication path.

Aspect 4. The memory-computing integrated chip architecture according to aspect 1, wherein arranging the one or more communication paths based on one or more of the operation property and the arrangement of the one or more arrays of memory-computing integrated cells of the plurality of first chips includes:
determining a position of each of the one or more arrays of memory-computing integrated cells at a corresponding first chip;
determining an operation state of each of the one or more arrays of memory-computing integrated cells, wherein the operation state includes an enabled operation state and a disabled operation state; and
arranging the one or more communication paths based on the position and the operation state, so that:
   arrays of memory-computing integrated cells of the one or more arrays of memory-computing integrated cells that are located at a same corresponding position at corresponding first chips and that are in the enabled operation state share a same communication path; and
   arrays of memory-computing integrated cells of the one or more arrays of memory-computing integrated cells that are located at different corresponding positions at corresponding first chips and/or that are in the disabled operation state are each coupled to a corresponding peripheral circuit **IP** core of the one or more peripheral circuit **IP** cores via a distinct communication path.

Aspect 5. The memory-computing integrated chip architecture according to any of aspects 2 to 4, wherein a quantity of second chips is one, and
wherein arranging the one or more communication paths based on one or more of the operation property and the arrangement of the one or more arrays of memory-computing integrated cells of the plurality of first chips includes:
numbering each of the one or more arrays of memory-computing integrated cells of the plurality of first chips;
numbering each of the one or more peripheral circuit **IP** cores of the second chip; and
arranging the one or more communication paths based on numbered arrays of memory-computing integrated cells and numbered peripheral circuit **IP** cores.

Aspect 6. The memory-computing integrated chip architecture according to any of aspects 2 to 4, wherein a quantity of second chips is greater than 1 and less than a quantity of the plurality of first chips.

Aspect 7. The memory-computing integrated chip architecture according to aspect 3 or 4, wherein a quantity of second chips is the same as a quantity of the plurality of first chips, so that each of the plurality of first chips corresponds to one second chip; and
where the one or more communication paths are arranged between each first chip and a corresponding second chip, so that each array of memory-computing integrated cells of each first chip is communicatively coupled to a corresponding peripheral circuit IP core of the second chip corresponding to the first chip.

Aspect 8. The memory-computing integrated chip architecture according to aspect 7, wherein the plurality of first chips and the second chips are arranged in a cross-stacked manner; or
the plurality of first chips are arranged above or below the second chips.

Aspect 9. The memory-computing integrated chip architecture according to any of aspects 1 to 8, further including:
one or more third chips, each integrated with one or more digital circuit IP cores.

Aspect 10. The memory-computing integrated chip architecture according to any of aspects 1 to 8, where the one or more arrays of memory-computing integrated cells are integrated to the plurality of first chips through a first process node, and the peripheral circuit IP core is integrated to the one or more second chips through a second process node different from the first process node.

Aspect 11. The memory-computing integrated chip architecture according to aspect 10, wherein a line width of the second process node is less than that of the first process node.

Aspect 12. The memory-computing integrated chip architecture according to any of aspects 1 to 8, wherein the one or more arrays of memory-computing integrated cells and the peripheral circuit IP core are integrated to the plurality of first chips and the one or more second chips through a same process node, respectively.

Aspect 13. The memory-computing integrated chip architecture according to any of aspects 1 to 8, wherein the one or more communication paths include a through-silicon via (TSV) structure and/or a hybrid bonding structure.

Aspect 14. The memory-computing integrated chip architecture according to any of aspects 1 to 8, wherein the one or more peripheral circuit IP cores include one or more of:
a programming circuit module, coupled to the one or more arrays of memory-computing integrated cells and configured to perform data programming on the one or more arrays of memory-computing integrated cells;
a digital-to-analog conversion module, coupled to the one or more arrays of memory-computing integrated cells and configured to convert digital data to be input to the one or more arrays of memory-computing integrated cells into analog data;
an analog-to-digital conversion module, coupled to the one or more arrays of memory-computing integrated cells and configured to convert analog data obtained through computing by the one or more arrays of memory-computing integrated cells into digital data;
a phase-locked loop;
an oscillator;
a sense amplifier; and
a temperature sensor.

Aspect 15. The memory-computing integrated chip architecture according to aspect 9, where the digital circuit **IP** core includes one or more of:
a post-processing operation circuit, configured to perform a post-processing operation on digital data converted by an analog-to-digital conversion module;
a random-access memory (RAM);
a central processing unit (CPU);
a graphics processing unit (GPU); and
a peripheral interface module.

Aspect 16. A packaging method for a memory-computing integrated chip, including:
integrating one or more arrays of memory-computing integrated cells of the memory-computing integrated chip to a plurality of first chips, wherein the one or more arrays of memory-computing integrated cells are used for computing with received data;
integrating one or more peripheral circuit **IP** cores of the memory-computing integrated chip to one or more second chips; and
packaging the plurality of first chips and the one or more second chips,
wherein the one or more arrays of memory-computing integrated cells are coupled to the one or more peripheral circuit **IP** cores via one or more communication paths, and wherein the one or more communication paths are arranged based on one or more of an operation property and an arrangement of the one or more arrays of memory-computing integrated cells of the plurality of first chips.

Aspect 17. An apparatus, including the memory-computing integrated chip architecture according to any of aspects 1 to 15.

Although the present disclosure has been illustrated and described in detail with reference to the accompanying drawings and the foregoing description, such illustration and description should be considered illustrative and schematic, rather than limiting; and the present disclosure is not limited to the disclosed embodiments. By studying the accompanying drawings, the disclosure, and the appended claims, those skilled in the art can understand and implement modifications to the disclosed embodiments when practicing the claimed subject matters. **In** the claims, the word "comprising" does not exclude other elements or steps not listed, the indefinite article "a" or "an" does not exclude plural, and the term "a plurality of" means two or more. The mere fact that certain measures are recited in different dependent claims does not indicate that a combination of these measures cannot be used to get benefit.

## Claims

1. A memory-computing integrated chip architecture (100), comprising:
a plurality of first chips (110), each integrated with one or more arrays of memory-computing integrated cells (112), wherein the one or more arrays of memory-computing integrated cells (112) are used for computing with received data; and
one or more second chips (120), each integrated with one or more peripheral circuit **IP** cores (122),
wherein the one or more arrays of memory-computing integrated cells (112) are coupled to the one or more peripheral circuit **IP** cores (122) via one or more communication paths (130), and the one or more communication paths (130) are arranged based on one or more of an operation property and an arrangement of the one or more arrays of memory-computing integrated cells (112) of the plurality of first chips (110).

2. The memory-computing integrated chip architecture (100) according to claim 1, wherein the one or more communication paths (130) are arranged based on the arrangement of the one or more arrays of memory-computing integrated cells (112) of the plurality of first chips (110);
the arrangement of the one or more arrays of memory-computing integrated cells (112) of the plurality of first chips (110) comprises a position of each of the one or more arrays of memory-computing integrated cells (112) at a corresponding first chip; and the one or more communication paths (130) are arranged based on the position, where arrays of memory-computing integrated cells of the one or more arrays of memory-computing integrated cells (112) of the plurality of first chips (110) that are located at a same corresponding position at corresponding first chips share a same communication path.

3. The memory-computing integrated chip architecture (100) according to claim 1, wherein the one or more communication paths (130) are arranged based on the operation property of the one or more arrays of memory-computing integrated cells (112) of the plurality of first chips (110);
the operation property of the one or more arrays of memory-computing integrated cells (112) of the plurality of first chips (110) comprises an operation state of each of the one or more arrays of memory-computing integrated cells (112), wherein the operation state comprises an enabled operation state and a disabled operation state; and
the one or more communication paths (130) are arranged based on the operation state, where each array of memory-computing integrated cells in the enabled operation state is coupled to a corresponding peripheral circuit **IP** core of the one or more peripheral circuit **IP** cores (122) via a distinct communication path.

4. The memory-computing integrated chip architecture (100) according to claim 1, wherein the one or more communication paths (130) are arranged based on the operation property and the arrangement of the one or more arrays of memory-computing integrated cells (112) of the plurality of first chips (110);
the arrangement of the one or more arrays of memory-computing integrated cells (112) of the plurality of first chips (110) comprises a position of each of the one or more arrays of memory-computing integrated cells (112) at a corresponding first chip;
the operation property of the one or more arrays of memory-computing integrated cells (112) of the plurality of first chips (110) comprises an operation state of each of the one or more arrays of memory-computing integrated cells (112), wherein the operation state comprises an enabled operation state and a disabled operation state; and
the one or more communication paths (130) are arranged based on the position and the operation state, where arrays of memory-computing integrated cells of the one or more arrays of memory-computing integrated cells (112) of the plurality of first chips (110) that are located at a same corresponding position at corresponding first chips and that are in the enabled operation state share a same communication path; and
arrays of memory-computing integrated cells of the one or more arrays of memory-computing integrated cells (112) of the plurality of first chips (110) that are located at different corresponding positions at corresponding first chips are each coupled to a corresponding peripheral circuit IP core of the one or more peripheral circuit IP cores (122) via a distinct communication path; or arrays of memory-computing integrated cells of the one or more arrays of memory-computing integrated cells (112) of the plurality of first chips (110) that are in the disabled state are each coupled to a corresponding peripheral circuit **IP** core of the one or more peripheral circuit **IP** cores (122) via a distinct communication path; or arrays of memory-computing integrated cells of the one or more arrays of memory-computing integrated cells (112) of the plurality of first chips (110) that are located at different corresponding positions at corresponding first chips and that are in the disabled state are each coupled to a corresponding peripheral circuit IP core of the one or more peripheral circuit IP cores (122) via a distinct communication path .

5. The memory-computing integrated chip architecture (100) according to any of claims 2 to 4, wherein a quantity of second chips is one, and
each of the one or more arrays of memory-computing integrated cells (112) of the plurality of first chips (110) is numbered; and each of the one or more peripheral circuit **IP** cores (122) of the second chip (120) is numbered; and
the one or more communication paths (130) is arranged based on numbered arrays of memory-computing integrated cells and numbered peripheral circuit IP cores.

6. The memory-computing integrated chip architecture (100) according to any of claims 2 to 4, wherein a quantity of second chips is greater than 1 and less than a quantity of the plurality of first chips.

7. The memory-computing integrated chip architecture (100) according to claim 3 or 4, wherein a quantity of second chips is the same as a quantity of the plurality of first chips, and each of the plurality of first chips corresponds to one second chip; and
wherein the one or more communication paths (130) are arranged between each first chip and a corresponding second chip, and each array of memory-computing integrated cells of each first chip is communicatively coupled to a corresponding peripheral circuit **IP** core of the second chip corresponding to the first chip.

8. The memory-computing integrated chip architecture (100) according to claim 7, wherein the plurality of first chips (110) and the second chips (120) are arranged in a cross-stacked manner; or
wherein the plurality of first chips (110) are arranged above or below the second chips (120).

9. The memory-computing integrated chip architecture (100) according to any of claims 1 to 8, further comprising:
one or more third chips, each integrated with one or more digital circuit IP cores.

10. The memory-computing integrated chip architecture (100) according to any of claims 1 to 8, where the one or more arrays of memory-computing integrated cells (112) are integrated to each of the plurality of first chips (110) through a first process node, and the one or more peripheral circuit IP core (122) are integrated to each of the one or more second chips (120) through a second process node different from the first process node.

11. The memory-computing integrated chip architecture (100) according to claim 10, wherein a line width of the second process node is less than that of the first process node.

12. The memory-computing integrated chip architecture (100) according to any of claims 1 to 8, wherein the one or more arrays of memory-computing integrated cells (112) are integrated to each of the plurality of first chips (110) through a process node that is the same as a process node through which the one or more peripheral circuit IP core (122) are integrated to each of the one or more second chips (120).

13. The memory-computing integrated chip architecture (100) according to any of claims 1 to 8, wherein the one or more communication paths (130) comprise one or more of a through-silicon via, TSV, structure and a hybrid bonding structure.

14. A packaging method (500) for a memory-computing integrated chip, comprising:
integrating (S510) one or more arrays of memory-computing integrated cells to each of a plurality of first chips, wherein the one or more arrays of memory-computing integrated cells are used for computing with received data;
integrating (S520) one or more peripheral circuit IP cores to each of one or more second chips; and
packaging (S530) the plurality of first chips and the one or more second chips,
wherein the one or more arrays of memory-computing integrated cells are coupled to the one or more peripheral circuit IP cores via one or more communication paths, and wherein the one or more communication paths are arranged based on one or more of an operation property and an arrangement of the one or more arrays of memory-computing integrated cells of the plurality of first chips.

15. An apparatus comprising the memory-computing integrated chip architecture according to any of claims 1 to 13.
